# EUROPEAN PATENT APPLICATION

(11) **EP 2 365 020 A1**
(43) Date of publication of application: **14.09.2011**
(21) Application number: 11157681.5
(22) Date of filing: 10.03.2011
(51) Int. Cl.: C08G 73/06, C08L 79/08, H01L 23/29

(54) **Resin Composition for Electronic Component Encapsulation and Electronic Component Device**

(30) Priority: 11.03.2010 JP 2010054135
(71) Applicant: NITTO DENKO CORPORATION, Osaka (JP)
(72) Inventor: Kitagawa, Yuya, Ibaraki-shi Osaka (JP); Tabuchi, Yasuko, Ibaraki-shi Osaka (JP)
(74) Representative: Grünecker, Kinkeldey, Stockmair & Schwanhäusser Anwaltssozietät

(57) **Abstract**

The present invention relates to a resin composition for electronic component encapsulation including: A: a cyanate ester resin; B: at least one selected from the group consisting of a phenol resin, a melamine compound and an epoxy resin; and C: an inorganic filler.

## Description

### FIELD OF THE INVENTION

The present invention relates to a resin composition for electronic component encapsulation which suppresses warpage of resin-encapsulated electronic component devices and also is excellent in heat resistance.

### BACKGROUND OF THE INVENTION

Recently, with regard to electronic component devices obtained by resin-encapsulation of electronic components such as semiconductor elements, condensers, transistors, and sensor devices, reduction in thickness and growth in size have been required. For example, in the case of a semiconductor device having a one-side encapsulated structure called as a ball grid array (BGA), since only one side of a semiconductor element mounted on a substrate is encapsulated, there may take place a problem that, owing to a difference in contraction between an encapsulating resin composed of a resin-cured product and the substrate, a stress is generated between the encapsulating resin and the substrate, so that warpage is generated on the package by the stress. In order to suppress the warpage, it has been investigated to decrease the difference in contraction between the encapsulating resin and the substrate by increasing glass transition temperature of the resin-cured product (Patent Document 1) or decreasing linear expansion coefficient of the resin-cured product (Patent Document 2).
Patent Document 1: JP-A-10-112515
Patent Document 2: JP-A-2006-286829

### SUMMARY OF THE INVENTION

However, in recent trend of reduction in thickness and growth in size of electronic component devices, it has been difficult to reduce warpage sufficiently.

The present invention is devised in consideration of such circumstances and an object of the invention is to provide a resin composition for electronic component encapsulation which suppresses the warpage of resin-encapsulated electronic component devices from both aspects of linear expansion coefficient and glass transition temperature and also is excellent in heat resistance.

Namely, the present invention relates to the following items 1 to 5.
1. A resin composition for electronic component encapsulation including:
   A: a cyanate ester resin;
   B: at least one selected from the group consisting of a phenol resin, a melamine compound and an epoxy resin; and
   C: an inorganic filler.
2. The resin composition for electronic component encapsulation according to item 1, in which the ingredient B is at least one selected from the group consisting of a phenol resin and a melamine compound.
3. The resin composition for electronic component encapsulation according to item 1 or 2, in which the ingredient A includes a cyanate ester resin represented by the formula (1); 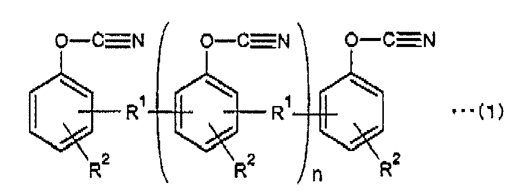 in which n is an integer of 0 to 20; R¹ is one selected from -CH₂-, -C(CH₃)₂-, -C(CF₃)₂-, -C(CH₃)H-, -O-, -S-, and a direct bond; and R² is one selected from -H, -CH₃, -C₂H₅, and -CF₃.
4. The resin composition for electronic component encapsulation according to any one of items 1 to 3, in which the ingredient B is contained in an amount of 2 to 20 parts by weight based on 100 parts by weight of the ingredient A.
5. An electronic component device obtained by encapsulating an electronic component with the resin composition for electronic component encapsulation according to any one items 1 to 4.

Since the resin composition for electronic component encapsulation of the invention contains a cyanate ester resin as an ingredient, the linear expansion coefficient of its cured product decreases and also glass transition temperature thereof increases, so that it becomes possible to perform resin-encapsulation with more reduced warpage of the electronic component device.

### DETAILED DESCRIPTION OF THE INVENTION

The following will explain embodiments of the invention in detail.

The invention relates to a resin composition for electronic component encapsulation, which contains the following ingredients A to C:
A: a cyanate ester resin,
B: at least one selected from the group consisting of a phenol resin, a melamine compound, and an epoxy resin, and
C: an inorganic filler.
The ingredient A is not particularly limited and any commercially available one can be used. Examples thereof include liquid to solid various cyanate ester resins, e.g., cyanate ester resins having a novolak skeleton, such as phenol novolak-type cyanate esters and cresol novolak-type cyanate esters, bivalent cyanate ester resins such as bis(3,5-dimethyl-4-cyanatophenyl)methane, bis(4-cyanatophenyl)methane, bis(3-methyl-4-cyanatophenyl)methane, bis(3-ethyl-4-cyanatophenyl)methane, bis(4- cyanatophenyl)-1,1-ethane, bis(4-cyanatophenyl)-2,2-propane, di(4-cyanatophenyl) ether, di(4-cyanatophenyl) thioether, 4,4'-{1,3-phenylenebis(1-methylethylidene)}biphenyl cyanate, and 2,2-bis(4-cyanatophenyl)-1,1,3,3,3-hexafluoropropane, trivalent cyanate ester resins such as tris(4-cyanatopehnyl)-1,1,1-ethane and bis(3,5-dimethyl-4-eyanatophenyl)-4-eyanatophenyl-1,1,1-ethane, and multivalent cyanate ester oligomer resins that are partial trimer compounds thereof. These cyanate ester resins may be used alone or two or more thereof may be used in combination. From the viewpoint of increasing the glass transition temperature of the cured product of the resin composition (hereinafter simply referred to as cured product), a cyanate ester resin represented by the formula (1) is preferred. Particularly, in view of productivity of the resin composition, the resin having a softening point or melting point of 50 to 120°C is more preferred. Of these, a cyanate ester resin represented by the formula (1) in which R¹ is -CH₂- and R² is -H is preferred.

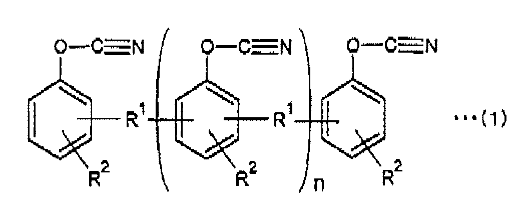

in which n is an integer of 0 to 20; R¹ is one selected from -CH₂-, -C(CH₃)₂-, -C(CF₃)₂-, -C(CH₃)H-, -O -S-, and a direct bond; and R² is one selected from -H, -CH₃, -C₂H₅, and -CF₃.

From the viewpoint of decreasing the linear expansion coefficient of the cured product, the content of the ingredient A is preferably 8 to 30% by weight, more preferably 12 to 18% by weight based on the whole resin composition,

The ingredient B is at least one selected from the group consisting of a phenol resin, a melamine compound and an epoxy resin.

The phenol resin, melamine compound, and epoxy resin are not particularly limited and, for example, the ingredients specifically shown below may be used alone or two or more thereof may be used in combination. Examples of the phenol resin include phenol novolak resins, triphenylmethane-type phenol resins, naphthalene-type phenol resins, phenol aralkyl resins, cresol novolak resins, biphenyl aralkyl resins, dicyclopentadiene-type phenol resins, and resol resins. Examples of the melamine compound include alkylolmelamines having an alkylol group and iminomelamines having an imino group. Examples of the epoxy resin include biphenyl-type epoxy resins, cresol novolak-type epoxy resins, bisphenol-type epoxy resins, and naphthalene-type epoxy resins. From the viewpoint of increasing the glass transition temperature of the cured product, it is preferred to use the phenol resin and/or melamine compound. Of these, it is preferred to use phenol novolak resins, triphenyhnethane-type phenol resins, or naphthalene-type phenol resins as the phenol resin or alkylolmelamines as the melamine compound.

From the viewpoint of moldability of the resin composition, the content of the ingredient B is preferably 2 to 20 parts by weight, more preferably 4 to 15 parts by weight based on 100 parts by weight of the ingredient A. By controlling the content of the ingredient B, gelation time of the resin composition can be changed to enhance the moldability.

The ingredient C is not particularly limited and hitherto known various fillers can be used. Examples thereof include powders of quartz glass, talc, silica (fused silica, crystalline silica, etc.), alumina, aluminum nitride, silicon nitride, and the like. They may be used alone or two or more thereof may be used in combination. Of these, from the viewpoint of decreasing the linear expansion coefficient of the crude product, it is preferred to use silica powders. Of the silica powders, it is more preferred to use fused silica powders. As the fused silica powders, a spherical fused silica powder and a crushed fused silica powder may be mentioned. From the viewpoint of fluidity of the resin composition, it is particularly preferred to use a spherical fused silica powder. Particularly, it is preferred to use the powder having an average particle diameter in the range of 0.1 to 40 µm. It is particularly preferred to use the powder having an average particle diameter in the range of 0.3 to 15 µm. The average particle diameter can be, for example, derived by measurement using a sample arbitrarily extracted from the parent population and using a laser diffraction/scattering particle size distribution analyzer.

From the viewpoint of decreasing the linear expansion coefficient of the cured product, the content of the ingredient C is preferably 70 to 92% by weight, more preferably 80 to 90% by weight based on the whole resin composition.

In the resin composition for electronic component encapsulation of the invention, other additives such as curing accelerators, flame retardants, and pigments including carbon black can be appropriately blended according to need, in addition to the above ingredients A to C.

The resin composition for electronic component encapsulation of the invention can be produced as follows, for example. Namely, the above ingredients A to C and, if necessary, the other additives are appropriately blended in a usual manner and melt-kneaded in a heated state using a kneader such as a mixing roller, followed by cooling and solidification at room temperature. Thereafter, the product is pulverized by a known method and, if necessary, is tableted. Thus, by such a series of steps, the objective resin composition for electronic component encapsulation can be produced.

The resin composition for electronic component encapsulation of the invention can be used as a tableted one as mentioned above, as a powder itself without tableting, or as a sheet-formed one.

Encapsulation of an electronic component with the resin composition for electronic component encapsulation thus obtained is not particularly limited and can be performed by any of known molding methods such as usual transfer molding (including transfer underfill), compression molding, and sheet encapsulation methods.

### EXAMPLES

The following will describe Examples together with Comparative Examples. However, the invention is not limited to these Examples.

First, individual ingredients shown below were prepared.

### [Cyanate ester resin a]

A cyanate ester resin where n represents 2 to 10, R¹ represents -CH₂-, and R² represents -H in the above formula (1) (PT-60 manufactured by Lonza Ltd., softening point: 60°C)

### [Cyanate ester resin b]

A cyanate ester resin where n represents 0, R¹ represents -C(CH₃)₂-, and R² represents -H in the above formula (1) (BA-3000 manufactured by Lonza Ltd., liquid at room temperature)

### [Phenol resin a]

A phenol novolak resin (GS-180 manufactured by Gun Ei Chemical Industry Co., Ltd., hydroxyl equivalent: 105, softening point: 83°C)

### (Phenol resin b]

A phenol aralkyl resin (MEH-7851-SS manufactured by Meiwa Plastic Industries, Ltd., hydroxyl equivalent: 203, softening point: 67°C)

### [Phenol resin c]

A triphenylmethane-type phenol resin (MEH-7500 manufactured by Meiwa Plastic Industries, Ltd., hydroxyl equivalent: 97, softening point: 111°C)

### [Melamine compound]

Dimethylolmelamine (S-176 manufactured by Nippon Carbide Industries Co., Inc.)

### [Epoxy resin a]

A biphenyl-type epoxy resin (YX-4000H manufactured by Japan Epoxy Resin, Co., Ltd., epoxy equivalent:195, softening point: 106°C)

### [Epoxy resin b]

A triphenylmethane-type epoxy resin (EPPN-501HY manufactured by Japan Epoxy Resin, Co., Ltd., epoxy equivalent: 169, softening point: 60°C)

### [Inorganic filler]

A fused spherical silica powder (average particle diameter: 31 µm) (FB-700 manufactured by Denki Kagaku Kogyo K.K.)

### [Releasing agent]

Polyethylene oxide wax (acid value: 17) (PED521 manufactured by Hoechst Ltd.)

### [Silane coupling agent]

3-Mercaptopropyltrimethoxysilane (KBM-803 manufactured by Shin-Etsu Chemical Co., Ltd.)

### [Curing accelerator]

2-Met,b,ylimidazole (2MZ manufactured by Shikoku Chemicals Corporation)

### [Examples 1 to 4, Comparative Examples 1 and 2]

Individual ingredients shown in the following Tables 1 and 2 were blended in the proportions shown in the tables and were melt-kneaded at 100°C for 3 minutes using a roll kneader, Then, the melted product was cooled and then pulverized to prepare a resin composition.

### [Linear expansion coefficient, glass transition temperature]

Using the resin composition obtained, a cured product (length: 20 mm, width: 3 mm, thickness 3 mm) was prepared by transfer molding (175°Cx3 minutes). The cured product obtained is post-cured (175°Cx5 hours, then 200°Cx4 hours, and finally 250°Cx4 hours) to prepare a test piece. It was measured at a temperature-elevating rate of 5°C/minute using a TMA apparatus (Model MG800GM) manufactured by Rigaku Corporation to determine linear expansion coeffcient and glass transition temperature. Tables 1 and 2 show the results.

**Table 1**

| | | | Example 1 | Example 2 | Example 3 | Example 4 |
|---|---|---|---|---|---|---|
| Composition (% by weight) | Cyanate ester resin | a | 15.0 | - | 15.8 | 13.7 |
| | | b | - | 15.0 | - | - |
| | Phenol resin | a | 1.5 | 1,5 | - | - |
| | | b | - | - | - | - |
| | | c | - | - | - | - |
| | Melamine resin | | - | - | 0.8 | - |
| | Epoxy resin | a | - | - | - | - |
| | | b | - | - | - | 13,7 |
| | Inorganic filler | | 83.0 | 83.0 | 82.9 | 72.0 |
| | Releasing agent | | 0.3 | 0.3 | 0.3 | 0.3 |
| | Silane Coupling agent | | 0.2 | 0.2 | 0.2 | 0.2 |
| | Curing accelerator | | - | - | - | - |
| Evaluation | Linear expansion coefficient (ppm) | | 7 | 9 | 7 | 10 |
| | Glass transition temperature (°C) | | 267 | 203 | 248 | 278 |

**Table 2**

| | | | Comparative Example 1 | Comparative Examples 2 |
|---|---|---|---|---|
| Composition (% by weight) | Cyanate ester resin | a | - | - |
| | | b | - | - |
| | Phenol resin | a | - | - |
| | | b | 8.4 | - |
| | | c | - | 5.1 |
| | Melamine resin | | - | - |
| | Epoxy resin Epoxy resin | a | 8.4 | - |
| | | b | - | 11.2 |
| | Inorganic filler | | 82.2 | 83.0 |
| | Releasing agent | | 0.4 | 0.3 |
| | Silane Coupling agent | | 0.2 | 0.2 |
| | Curing accelerator | | 0.5 | 0.1 |
| Evaluation | Linear expansion coefficient (ppm) | | 14 | 13 |
| | Glass transition temperature (°C) | | 125 | 242 |

The linear expansion coefficient of a ceramic substrate that is a common substrate is 7 ppm. Therefore, the resin composition for electronic component encapsulation of the invention can made the linear expansion coefficient of its cured product close to the linear expansion coefficient of the substrate and has a high glass transition temperature, so that warpage of resin-encapsulated electronic component devices can be further suppressed. Moreover, since the glass transition temperature is high, heat resistance is also satisfactory.

While the invention has been described in detail with reference to specific embodiments thereof, it will be apparent to one skilled in the art that various changes and modifications can be made therein without departing from the spirit and scope thereof.
Incidentally, the present application is based on Japanese Patent Application No. 2010-054135 filed on March 11, 2010, and the contents are incorporated herein by reference.
All references cited herein are incorporated by reference herein in their entirety.
Also, all the references cited herein are incorporated as a whole.

Since the resin composition for electronic component encapsulation of the invention contains a cyanate ester resin as an ingredient, the linear expansion coefficient of its cured product decreases and also glass transition temperature thereof increases, so that it becomes possible to perform resin-encapsulation with more reduced warpage of the electronic component device.

## Claims

1. A resin composition for electronic component encapsulation comprising:
A: a cyanate ester resin;
B: at least one selected from the group consisting of a phenol resin, a melamine compound and an epoxy resin; and
C: an inorganic filler.

2. The resin composition for electronic component encapsulation according to claim 1, wherein the ingredient B is at least one selected from the group consisting of a phenol resin and a melamine compound.

3. The resin composition for electronic component encapsulation according to claim 1 or 2, wherein the ingredient A comprises a cyanate ester resin represented by the formula (1): 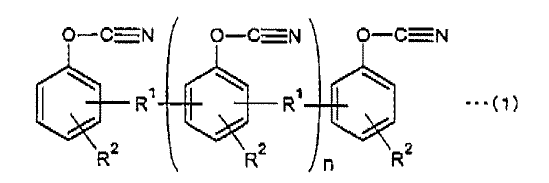 wherein n is an integer of 0 to 20; R¹ is one selected from -CH₂-, -C(CH₃)₂-, -C(CF₃)₂-, -C(CH₃)H-, -O-, -S-, and a direct bond; and R² is one selected from -H, -CH₃, -C₂H₅, and -CF₃.

4. The resin composition for electronic component encapsulation according to any one of claims 1 to 3, wherein the ingredient B is contained in an amount of 2 to 20 parts by weight based on 100 parts by weight of the ingredient A.

5. An electronic component device obtained by encapsulating an electronic component with the resin composition for electronic component encapsulation according to any one of claims 1 to 4.
